(19) **Europäisches Patentamt / European Patent Office / Office européen des brevets**

(11) **EP 3 823 798 B1**

(12) **FASCICULE DE BREVET EUROPEEN**

(45) Date de publication et mention de la délivrance du brevet:
**31.08.2022 Bulletin 2022/35**

(21) Numéro de dépôt: **19735568.8**

(22) Date de dépôt: **04.07.2019**

(51) Classification Internationale des Brevets (IPC):
**B25J 13/08** (2006.01)     **B25J 19/00** (2006.01)
**B25J 19/06** (2006.01)

(52) Classification Coopérative des Brevets (CPC):
**B25J 13/086; B25J 19/0025; B25J 19/06**

(86) Numéro de dépôt international:
**PCT/EP2019/067952**

(87) Numéro de publication internationale:
**WO 2020/016019 (23.01.2020 Gazette 2020/04)**

(54) **APPAREIL MUNI D'UNE DETECTION CAPACITIVE ET DE LIGNE(S) ELECTRIQUE(S)**

VORRICHTUNG MIT KAPAZITIVEM SENSOR UND ELEKTRISCHER LEITUNG

APPARATUS HAVING A CAPACITIVE SENSING SYSTEM AND ELECTRIC LINE(S)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.07.2018 FR 1856647**

(43) Date de publication de la demande:
**26.05.2021 Bulletin 2021/21**

(73) Titulaire: **Fogale Nanotech**
**30900 Nimes (FR)**

(72) Inventeurs:
• **CHAKOUR, Yacine**
**30210 Sernhac (FR)**
• **ROZIERE, Didier**
**30900 Nîmes (FR)**
• **COURTEVILLE, Alain**
**30111 Congenies (FR)**

(74) Mandataire: **IPAZ**
**Bâtiment Platon**
**Parc Les Algorithmes**
**91190 Saint-Aubin (FR)**

(56) Documents cités:
**JP-A- 2013 123 760     US-A- 5 166 679**
**US-A- 5 363 051**

## Description

La présente invention concerne un appareil, tel qu'un robot, muni d'une détection capacitive d'objet(s) et d'au moins une ligne électrique.

Le domaine de l'invention est, de manière non limitative, celui du domaine de la robotique, en particulier le domaine de la robotique industrielle ou des robots de service, par exemple médical ou domestique, ou encore des robots collaboratifs, également appelés « cobots ».

## Etat de la technique

Dans le domaine de la robotique collaborative, les robots peuvent être équipés de capteurs capacitifs pour détecter l'approche d'objets ou d'opérateurs humains dans le voisinage dudit robot. Ces capteurs peuvent par exemple comprendre des électrodes capacitives agencées sous la forme de surfaces sensibles qui recouvrent au moins partiellement la surface du robot. Ces électrodes capacitives sont polarisées à un potentiel d'excitation alternatif, et reliées à une électronique de détection qui mesure le couplage capacitif entre ces électrodes et des objets polarisés à un potentiel différent des électrodes, le plus souvent la masse.

On connait par exemple du document US 5 166 679 A un robot, selon le préambule de la revendication 1, comprenant au moins une électrode de mesure et une électronique de détection capacitive.

Ces robots sont en général équipés d'outils ou d'accessoires, référencés à la masse, et reliés à des électroniques de commande ou des alimentations par des câbles électriques qui passent dans des chemins de câble le long du robot.

Lorsque ces câbles sont à proximité d'une surface de capteurs capacitifs, ils peuvent être détectés comme des obstacles et déclencher des procédures de sécurité de manière erronée. Ces câbles peuvent aussi perturber le fonctionnement des capteurs capacitifs en termes de précision et de portée de détection.

Une solution peut être d'éloigner ces câbles de sorte qu'ils sont hors de la zone détection des capteurs capacitifs. Mais cette solution présente un risque de collision entre un objet et lesdits câbles.

Un but de la présente invention est de pallier ces inconvénients.

Un autre but de l'invention est de proposer une solution permettant le passage d'un câble polarisé un potentiel différent du potentiel d'un capteur capacitif, à proximité dudit capteur capacitif, sans perturber le fonctionnement dudit capteur capacitif.

Il est aussi un but de la présente invention de proposer une solution permettant le passage d'un câble polarisé un potentiel différent du potentiel d'un capteur capacitif, à proximité dudit capteur capacitif, sans présenter de risques de collision avec es objets environnants.

## Exposé de l'invention

Au moins un de ces buts est atteint avec un appareil comprenant :

- au moins une électrode, dite de mesure, polarisée à un potentiel électrique alternatif, dit de détection, différent d'un potentiel de masse, à une fréquence, dite de détection, pour détecter au moins un objet dans une zone de détection, et
- au moins une électronique de détection capacitive, reliée auxdites électrodes de mesure, pour détecter un signal relatif à un couplage capacitif entre ledit objet et au moins une électrode de mesure.

L'appareil selon l'invention est caractérisé en ce qu'il comprend en outre :

- une ligne électrique comprenant au moins un fil électrique, dans ladite zone de détection,
- au moins un moyen d'écartement de ladite ligne électrique pour la positionner à une distance de l'au moins une électrode de mesure comprise entre :

  - une distance, dite minimale, correspondant à la distance au-delà de laquelle une ligne électrique, dite de référence, avec une dimension prédéterminée, génère une capacité de couplage avec l'au moins une électrode de mesure, inférieure à une capacité seuil prédéterminée ; et
  - une distance, dite maximale, correspondant à la distance au-delà de laquelle un objet, dit de référence, avec une dimension prédéterminée, supérieure à la dimension de ladite ligne électrique de référence, génère une capacité de couplage avec l'au moins une électrode de mesure inférieure à ladite capacité seuil.

Autrement dit, l'invention propose de :

- choisir une ligne électrique de référence avec une dimension prédéterminée, et un objet de référence avec une dimension prédéterminée supérieure à celle de ladite ligne électrique de référence ;
- déterminer une distance, dite distance minimale, à partir de laquelle la capacité de couplage entre ladite ligne électrique de référence et l'électrode de mesure est inférieure à la capacité seuil prédéterminée ; et
- déterminer une distance, dite distance maximale, à partir de laquelle la capacité de couplage entre ledit objet de référence et l'électrode de mesure est inférieure à la capacité seuil prédéterminée.

Une fois la distance minimale et la distance maximale déterminées, utiliser un moyen d'écartement pour positionner la ligne électrique de l'appareil entre lesdites distances minimale et maximale.

Ainsi, le dispositif selon l'invention propose un positionnement spécifique de la ligne électrique par rapport aux électrodes de mesure capacitives. Par conséquent, le dispositif selon l'invention permet d'éviter les perturbations, ou erreurs de détection, dues à la détection de la ligne électrique par les capteurs de mesure. En même temps, le dispositif selon l'invention permet d'éviter les risques de collision entre la ligne électrique et les objets environnants puisque ces objets, eux, sont détectés lorsqu'ils s'approchent de la ligne électrique.

Dans la présente demande, deux potentiels alternatifs sont identiques à une fréquence donnée lorsqu'ils comportent chacun une composante alternative identique ou similaire à cette fréquence, c'est-à-dire de même amplitude (par exemple à quelques pourcents près) et de même phase (par exemple à quelques degrés près). Ainsi, l'un au moins des deux potentiels identiques à ladite fréquence peut comporter en outre une composante continue, et/ou une composante alternative de fréquence différente de ladite fréquence donnée.

De manière similaire, deux potentiels alternatifs sont différents à la fréquence donnée lorsqu'ils ne comportent pas de composante alternative identique ou similaire à cette fréquence donnée.

Dans la présente demande, le terme « potentiel de masse » ou « potentiel de masse générale » désigne un potentiel de référence de l'électronique, de l'appareil ou de son environnement, qui peut être par exemple une masse électrique. Ce potentiel de masse peut correspondre à un potentiel de terre, ou à un autre potentiel relié ou non au potentiel de terre.

On rappelle par ailleurs que de manière générale, les objets qui ne sont pas en contact électrique direct avec un potentiel électrique particulier (objets électriquement flottants) tendent à se polariser par couplage capacitif au potentiel électrique d'autres objets présents dans leur environnement, tel que par exemple la terre ou des électrodes, si les surfaces de recouvrement entre ces objets et ceux de l'environnement (ou les électrodes) sont suffisamment importantes.

Dans la présente demande, « objet » désigne tout objet, ou toute personne, pouvant se trouver dans l'environnement de l'appareil.

Préférentiellement, la capacité seuil peut être déterminée en prenant en compte :

1. une capacité limite de détection, dépendant d'un niveau de bruit de détection de l'électronique de détection capacitive ; et/ou
2. une capacité à l'infini, telle que mesurée par l'électronique de détection capacitive en l'absence d'objet ou de ligne électrique.

La capacité à l'infinie est la capacité qui apparaît entre les électrodes et l'environnement, du fait de la présence des charges électriques dans l'électrode, et d'éventuels éléments de l'environnement. Elle correspond donc à une limite asymptotique de la détection. Elle peut être en outre variable en fonction de la configuration ou de la position de l'appareil sur lequel sont les électrodes sont positionnées. Dans ce cas, la capacité seuil peut être déterminée en prenant en compte une capacité à l'infinie dans une configuration particulière de l'appareil et/ou de son environnement.

Le niveau de bruit de détection peut prendre en compte, notamment, des bruits électroniques et des instabilités de gain et d'offset.

La capacité limite de détection peut être déterminée à partir de ce niveau de bruit de détection, et d'un rapport signal à bruit acceptable. La capacité limite de détection peut par exemple correspondre à 10 fois le niveau de bruit de détection.

De manière générale, la capacité seuil peut être définie comme une capacité, telle que mesurée par l'électronique de détection capacitive, à partir de laquelle on considère qu'un objet distinct de l'environnement de l'appareil est présent et détecté. Inversement, on peut alors considérer qu'aucun objet n'est présent lorsque la capacité mesurée est inférieure à cette capacité seuil.

De manière non limitative, cette capacité seuil peut être définie comme, ou à partir de, une capacité à l'infini, augmentée de la capacité limite de détection, ou d'une quantité dépendant d'un niveau de bruit de détection de l'électronique de détection capacitive.

Ainsi, toute ligne électrique de dimension inférieure ou égale à celle de la ligne électrique de référence, n'est plus détectée lorsqu'elle se trouve au-delà de la distance minimale. De plus, tout objet de dimension supérieure ou égale à celle de l'objet de référence, est détecté lorsqu'il se trouve en deçà de la distance maximale.

Par conséquent, dans l'intervalle de distance comprise entre la distance minimale et la distance maximale :

1. toute ligne électrique, de dimension égale ou inférieure à celle de la ligne de référence, n'est pas détectée ; alors que
2. tout objet, de dimension égale ou supérieure à celle de l'objet de référence, est détecté.

Avantageusement, la dimension de la ligne électrique de référence peut correspondre à un diamètre total des conducteurs de ladite ligne de référence.

Ce diamètre total peut être défini comme le diamètre d'un cercle englobant tous les conducteurs de la ligne.

Ainsi, le diamètre total de la ligne électrique de référence utilisée pour les calculs doit être choisi de sorte que le diamètre, ou le diamètre total, de la ligne électrique utilisée dans l'appareil en pratique soit inférieur au diamètre total de ladite ligne électrique de référence. Ou inversement, la ligne électrique utilisée dans l'appareil doit avoir un diamètre total inférieur ou égal au diamètre total de la ligne électrique de référence.

La dimension de l'objet de référence peut correspondre à :

3. une largeur ou une longueur de l'objet de référence ; ou

4. une largeur ou une longueur d'un objet de référence, éventuellement fictif, de même largeur ou de même longueur que l'au moins une électrode de mesure.

La deuxième condition peut correspondre au fait que la dimension à prendre en compte pour déterminer une capacité de couplage entre un objet de référence et une électrode est la plus petite des deux dimensions, qui correspond au recouvrement des surfaces.

Comme expliqué plus haut, la distance maximale de positionnement de la ligne électrique, notée $D_{max}$, correspond de fait à la borne supérieure de la zone de détection des électrodes de mesure, qui est définie comme la distance maximale à laquelle un objet de référence, ou un opérateur de référence, avec une surface minimale, notée $S_{min,o}$, pourrait être détecté dans l'air par les électrodes de mesure, et donc générer une capacité seuil, notée $C_{min}$, correspondant, par exemple, à la capacité minimale exploitable par l'électronique de détection, au sens du seuil de bruit ou de la capacité à l'infini comme décrit précédemment.

Cette distance maximale $D_{max}$ est évaluée avec un diélectrique de type air ($\varepsilon_r = 1$) qui est la condition la plus défavorable.

L'objet de référence peut être par exemple une main. La surface $S_{min,o}$ minimale peut être définie comme la surface de recouvrement entre une électrode de mesure et l'objet de référence.

La distance minimale de positionnement de la ligne, notée $D_{min}$, correspond à la distance à partir de laquelle la ligne électrique de référence commence à être détectée par les électrodes de mesure. Cela est réalisé lorsque la capacité électrode-ligne, notée $C_{el}$, est égale à la capacité minimum $C_{min}$.

Dans la mesure où la ligne électrique de référence peut être entourée de gaines et surtout fixée sur des éléments de fixation, il est possible de prendre en compte une permittivité relative $\varepsilon_r$ dans le calcul de la capacité de couplage de la ligne électrique $C_{el}$. On a donc :

$$C_{el} = C_{min} \quad (1)$$

Soit, en remplaçant $C_{el}$ et $C_{min}$ par leurs expressions respectives selon la formule du condensateur plan :

$$\frac{\varepsilon_0\,\varepsilon_r\,S_{min,c}}{D_{min}} = \frac{\varepsilon_0\,S_{min,o}}{D_{max}} \quad (2)$$

où $S_{min,c}$ est la surface de recouvrement entre la ligne électrique de référence et l'électrode de mesure. On obtient ainsi :

$$D_{min} = \frac{\varepsilon_r\,S_{min,c}}{S_{min,o}}\,D_{max} \quad (3)$$

On obtient ainsi une distance d'écartement de la ligne électrique de référence, notée D, par rapport aux électrodes de mesure :

$$\frac{\varepsilon_r\,S_{min,c}}{S_{min,o}}\,D_{max} < D < D_{max} \quad (4)$$

La distance minimale de positionnement de la ligne $D_{min}$ dépend ainsi du rapport des surfaces de la ligne électrique de référence et de l'objet de référence, et de la permittivité diélectrique relative entre la ligne électrique de référence et les électrodes de mesure.

En pratique, on peut faire les approximations suivantes :

1. les électrodes de mesure peuvent être rectangulaires ou carrées avec une dimension (largeur ou longueur) de l'ordre de 50 mm ou 70 mm ;

2. l'objet de référence peut correspondre à une main d'opérateur, par exemple de dimension (largeur) 90 à 100 mm ; et

3. les lignes électriques utilisées ont un diamètre (ou un diamètre total équivalent en tenant compte des courbures des lignes de champ diélectriques) de l'ordre de 2 à 10 mm.

On peut aussi supposer, sans trop de perte de généralité, que l'objet de référence, la ligne électrique de référence et l'électrode de mesure peuvent être approximées par des formes rectangulaires. On peut également supposer que l'objet de référence et la ligne électrique de référence sont tous deux plus grands que l'électrode de mesure selon une dimension, par exemple la longueur.

Avec toutes ces approximations, et de manière nullement limitative, la distance minimale et la distance maximale peuvent être choisie de sorte à vérifier la relation suivante :

$$D_{min} = \frac{\varepsilon_r L_c}{L_o} D_{max} \quad (5)$$

avec :

1. $D_{min}$ la distance minimale,

2. $D_{max}$ la distance maximale,

3. $\varepsilon_r$ la permittivité relative globale (ou moyenne) du moyen d'écartement,

4. $L_c$ la dimension de la ligne électrique de référence, et

5. $L_o$ la dimension de l'objet de référence.

Au moins un moyen d'écartement peut être réalisé par tout procédé de fabrication, et en particulier par moulage, par injection, par usinage, par impression 3D etc.

Préférentiellement, au moins un moyen d'écartement peut présenter une permittivité diélectrique relative globale (ou moyenne) inférieure ou égale à 2, en particulier à 1,5.

Ainsi, l'influence du moyen d'écartement sur la détection capacitive est diminuée, voire négligeable, et il est possible de minimiser la distance minimale $D_{min}$.

Le moyen d'écartement peut être réalisé par, ou comprendre, au moins un matériau diélectrique tel que du plastique, un polymère (polychlorure de vinyle PVC, polyuréthane, polyester, polyamide, acrylonitrile butadiène styrène ABS, ...), ou même du bois, du verre.

Au moins un moyen d'écartement peut être fixé à une surface de l'appareil selon l'invention, en particulier à une surface externe dudit appareil.

Alternativement, ou en plus, au moins un moyen d'écartement peut être fixé à la ligne électrique, et en particulier autour de la ligne électrique.

De plus, au moins un moyen d'écartement peut s'étendre uniquement ou essentiellement entre l'appareil selon l'invention et la ligne électrique.

Par conséquent, le moyen d'écartement se trouve entièrement entre la ligne électrique et l'appareil selon l'invention, à l'exception éventuelle d'un élément de fixation ou d'une bride autour du câble.

Alternativement, ou en plus, au moins un moyen d'écartement peut s'étendre au-delà de la ligne électrique, vue depuis l'au moins une électrode de mesure.

Ainsi, un tel moyen d'écartement permet de constituer une surface de contact se trouvant au-delà de la ligne électrique, de sorte qu'il protège la ligne électrique contre des chocs avec des objets ou des surfaces externes, et/ou inversement qu'il protège des objets d'un contact direct avec la ligne électrique.

Suivant une caractéristique particulièrement avantageuse, la hauteur d'au moins un moyen d'écartement peut être ajustable, et/ou variable.

Ainsi, il est possible de s'adapter, en particulier à la volée, à différentes dimensions de lignes électriques, en cas par exemple de modification, d'ajout, de suppression, ou de remplacement d'une ligne électrique.

Au moins un moyen d'écartement peut être rigide.

Alternativement ou en plus, au moins un moyen d'écartement peut être souple.

Un tel moyen d'écartement permet de ne pas abimer la ligne électrique ou l'appareil lorsque l'appareil comporte une partie articulée le long de laquelle la ligne électrique se prolonge.

En effet, la modification de la position, et en particulier de l'orientation d'une telle partie articulée, peut faire vérifier l'écartement entre la ligne électrique et ladite partie articulée. Le fait d'utiliser un moyen d'écartement souple permet d'accepter ces variations d'écartement sans abimer la ligne électrique.

Une telle situation peut se produire, en particulier, lorsque l'appareil selon l'invention est bras robotisé comportant des segments articulés.

En outre, la souplesse permet d'absorber ou de minimiser des chocs avec des objets en cas de contact direct avec la ligne électrique ou le moyen d'écartement.

En particulier, au moins un moyen d'écartement peut être souple et s'étendre au-delà de la ligne électrique, vue depuis l'au moins une électrode de mesure.

Cette configuration permet d'absorber ou de minimiser des chocs avec des objets en cas de contact direct avec le moyen d'écartement. Elle peut en outre permettre de générer un déplacement de la ligne électrique en cas d'appui vers les électrodes de mesure, de sorte que cette ligne devienne détectable et permette ainsi une détection de l'appui.

Avantageusement, au moins un moyen d'écartement peut être gonflable, et/ou se présenter sous la forme d'une brosse cylindrique à poils radiaux, et/ou être au moins en partie, creux, ou spongieux, ou sous forme de mousse.

Un tel moyen d'écartement présente notamment une permittivité diélectrique relative diminuée, du fait d'une forte proportion d'air dans le volume.

L'appareil selon l'invention peut en outre comprendre au moins une électrode, dite de garde, agencée du côté opposé à la zone de détection par rapport aux électrodes de mesure, et polarisée à un potentiel, dit de garde, identique au potentiel de détection à la fréquence de détection.

Une telle au moins une électrode de garde vient protéger la ou les électrodes de mesure contre les capacités de fuite ou de couplage parasite, ou des perturbations, pouvant être causées par des parties de l'appareil, qui ne seraient pas au potentiel de détection, à la fréquence de détection. Ainsi, la portée et la précision de détection capacitive sont améliorées.

La ou les électrodes de garde peu(ven)t être disposée(s) sous la ou les électrodes de mesure, du côté opposé à la zone de détection.

La détection capacitive mise en œuvre dans l'appareil selon l'invention est basée sur la mesure/détection d'un signal de couplage capacitif entre au moins une électrode de mesure et l'objet à détecter.

Pour ce faire, l'électronique de détection capacitive peut comprendre une électronique de mesure pour d'une part :

- fournir le potentiel de détection, et le potentiel de garde le cas échéant, à la fréquence de détection ; et
- mesurer/détecter un signal relatif au couplage électrode-objet.

Suivant un exemple de réalisation, l'électronique de mesure peut comprendre un amplificateur opérationnel (AO), ou un circuit réalisant un amplificateur opérationnel, fonctionnant en amplificateur de transimpédance ou de charge, dont :

- une première entrée, par exemple inverseuse, est reliée à une ou des électrodes de mesure, directement ou par l'intermédiaire d'un moyen de scrutation optionnelle par exemple ;
- une deuxième entrée, par exemple non inverseuse, est reliée à un oscillateur fournissant le potentiel de détection et le potentiel de garde ; et
- la sortie est rebouclée sur ladite première entrée par l'intermédiaire d'une impédance, et en particulier d'une capacité.

Dans cette configuration, la sortie de l'AO fournit une tension $V_s$ dont l'amplitude est proportionnelle à la capacité électrode-objet, notée $C_{eo}$, entre au moins une électrode de mesure et l'objet.

La sortie de l'amplificateur opérationnel peut être reliée, directement ou indirectement, à un module de mesure de la tension $V_s$. Ce module de mesure de la tension $V_s$ peut comprendre un conditionneur, une démodulation telle qu'une démodulation synchrone à la fréquence de détection, ou une détection d'amplitude.

L'électronique de détection peut en outre comprendre un oscillateur fournissant le potentiel alternatif de détection, et le potentiel de garde le cas échéant.

Avantageusement, l'électronique de détection peut être, au moins en partie, référencée électriquement au potentiel de détection.

L'électronique de détection peut en outre comprendre au moins un module de calcul agencé pour déterminer une distance ou une information de distance, et/ou un contact ou une information de contact, entre au moins une électrode de mesure et l'objet, en fonction du signal relatif à la capacité de couplage $C_{eo}$ issu du conditionneur.

Ce module de calcul peut par exemple comprendre ou être réalisé sous la forme d'un microcontrôleur, ou d'un FPGA.

Le module de calcul peut également fournir d'autres informations, telles que des déclenchements d'alarmes ou de procédures de sécurité, lorsque par exemple les distances mesurées sont inférieures à des seuils de distance prédéterminés.

Bien entendu, l'électronique de détection peut comprendre d'autres composants que ceux décrits.

L'électronique de détection peut être réalisée par des composants numériques, ou par des composants analogiques, ou encore par une combinaison de composants numériques et de composants analogiques.

Dans l'appareil selon l'invention, au moins une ligne électrique peut être une ligne d'alimentation, et/ou de commande de, et/ou de communication avec, un organe électrique dudit appareil.

L'appareil selon l'invention peut se présenter sous la forme d'un robot.

Suivant des exemples de réalisation nullement limitatifs, le robot peut être ou comprendre tout système robotisé.

Il peut en particulier se présenter sous la forme de, ou comprendre, par exemple un bras robotisé, un robot mobile, un véhicule sur roues ou chenilles tel qu'un chariot muni d'un bras ou d'un système manipulateur, ou un robot de type humanoïde, gynoïde ou androïde, éventuellement pourvu d'organes de déplacement tels que des membres.

En particulier, l'appareil selon l'invention peut être un robot, en particulier un bras robotisé, comprenant au moins deux segments reliés entre eux par une articulation, et comprenant au moins un moyen d'écartement au niveau de ladite articulation.

## Description des figures et modes de réalisation

D'autres avantages et caractéristiques apparaîtront à l'examen de la description détaillée d'exemples nullement limitatifs, et des dessins annexés sur lesquels :

- la FIGURE 1 est une représentation schématique d'un exemple de réalisation non limitatif d'une électronique de détection capacitive pouvant être mise en œuvre dans un appareil selon l'invention ;
- les FIGURES 2-4 sont des représentations schématiques d'exemples non limitatifs de moyens d'écartement pouvant être utilisés dans un appareil selon l'invention ; et
- la FIGURE 5 est une représentation schématique d'un exemple d'appareil selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

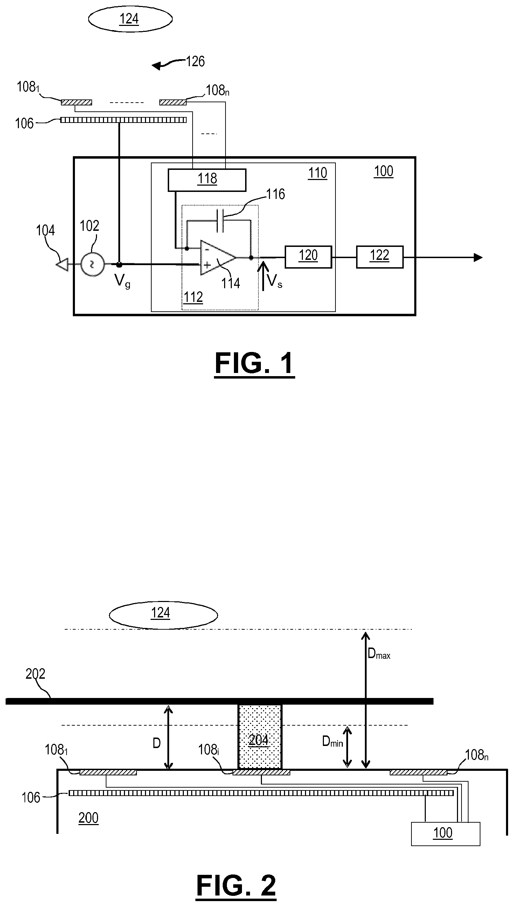

La FIGURE 1 est une représentation schématique d'un exemple de réalisation non limitatif d'une électronique de détection capacitive pouvant être mise en œuvre dans un appareil selon l'invention.

L'électronique de détection 100, représentée sur la FIGURE 1, peut être réalisée sous une forme analogique ou numérique, ou une combinaison analogique/numérique.

L'électronique de détection 100 comprend un oscillateur 102 délivrant une tension alternative, notée $V_G$, et référencé à un potentiel de masse 104.

La tension $V_G$ est utilisée comme potentiel de garde pour polariser une ou des électrodes de garde 106 par l'intermédiaire d'une ligne ou plusieurs lignes, et comme potentiel d'excitation pour polariser des électrodes de mesure $108_1$-$108_n$, pouvant être également désignée par la référence 108, ou la référence 108i, dans la suite. Elle peut être de toute forme d'onde, par exemple sinusoïdale ou carrée, à une fréquence ou une fréquence fondamentale correspondant à la fréquence de détection.

L'électronique de détection 100 comprend une électronique de mesure 110 pour polariser les électrodes de mesure 108 et mesurer un signal relatif à une capacité électrode-objet $C_{eo}$ entre un objet au moins une électrode de mesure 108.

L'électronique de mesure 110 comprend un amplificateur de courant, ou de charge, 112 représenté par un amplificateur opérationnel (AO) 114 et une capacité de contre-réaction 116 rebouclant la sortie de l'AO 114 à l'entrée inverseuse « - » de l'AO 114.

De plus, dans l'exemple représenté, l'entrée non-inverseuse « + » de l'AO 114 reçoit la tension $V_G$ et l'entrée inverseuse « - » de l'AO 114 est prévue pour être reliée à chaque électrode de mesure 108i par l'intermédiaire d'un moyen de scrutation 118, qui peut être par exemple un switch, de sorte à interroger individuellement à tour de rôle les électrodes de mesure 108.

L'utilisation du moyen de scrutation 118 est, bien entendu, optionnelle.

Dans ces conditions, l'amplificateur de charge 112, et en particulier l'AO 114, fournit en sortie une tension $V_S$ d'amplitude proportionnelle à la capacité de couplage $C_{eo}$ entre une ou plusieurs électrodes de mesure 108 reliée à son entrée « - » et un objet à proximité, ou en contact, de ladite électrode de mesure 108.

L'électronique de mesure 110 peut en outre comprendre un conditionneur 120 permettant d'obtenir un signal représentatif de la capacité de couplage $C_{eo}$ recherchée. Ce conditionneur 120 peut comprendre, par exemple, un démodulateur synchrone pour démoduler le signal par rapport à une porteuse, à la fréquence de détection. Le conditionneur 120 peut également comprendre un démodulateur asynchrone ou un détecteur d'amplitude. Ce conditionneur 120 peut, bien entendu, être réalisé sous une forme analogique et/ou numérique (microprocesseur) et comprendre tous moyens nécessaires de filtrage, de conversion, de traitement, etc.

Le conditionneur 120 mesure et fournit la valeur de la tension $V_S$.

L'électronique de détection 100 peut en outre comprendre un module de calcul 122 agencé pour déterminer une distance ou une information de distance, et/ou un contact ou une information de contact, entre au moins une électrode de mesure 108 et un objet, en fonction du signal relatif à la capacité de couplage $C_{eo}$ issu du conditionneur 120.

Ce module de calcul 122 peut par exemple comprendre ou être réalisé sous la forme d'un microcontrôleur, ou d'un FPGA.

Le module de calcul 122 peut également fournir d'autres informations, telles que des déclenchements d'alarmes ou de procédures de sécurité, lorsque par exemple les distances mesurées sont inférieures à des seuils de distance prédéterminés.

Bien entendu, l'électronique de détection 100 peut comprendre d'autres composants que ceux décrits.

L'électronique de détection 100, ou au moins sa partie sensible avec l'amplificateur de charge 112 peut être référencée (ou alimentée par des alimentations électriques référencées) au potentiel de garde $V_G$, pour minimiser les capacités parasites.

L'électronique de détection 100 peut également être référencée, de manière plus classique, au potentiel de masse 104.

Ainsi, lorsqu'un objet 124 entre dans la zone de détection 126 de la ou des électrodes de mesure $108_1$-$108_n$, cet objet 124 vient en couplage capacitif avec au moins une électrode de mesure 108, ce qui modifie la capacité vue par cette électrode de mesure 108, et donc l'amplitude de la tension $V_S$ mesurée par l'électronique de mesure 110 reliée à cette électrode de mesure 108.

La FIGURE 2 est une représentation schématique d'un exemple de réalisation non limitatif d'un appareil selon l'invention

La FIGURE 2 représente, de manière très partielle un appareil 200, qui peut par exemple être un robot.

L'appareil 200 comprend des électrodes de mesure $108_1$-$108_n$, une électrode de garde unique 106. Alternativement, l'appareil 200 peut comprendre plusieurs électrodes de garde.

L'appareil 200 comprend également une électronique de détection, et en particulier l'électronique de détection 100 de la FIGURE 1.

L'appareil 200 est muni d'une ligne électrique 202. La ligne électrique 202 peut par exemple être prévue pour alimenter, ou communiquer avec, un organe électrique (non représenté) dudit appareil 200.

L'appareil 200 est en outre équipé d'un moyen d'écartement 204. Le moyen d'écartement 204 a pour fonction d'écarter la ligne électrique 202, par rapport aux électrodes de mesure 108, d'une distance D comprise entre :

- une distance minimale, notée $D_{min}$, au-delà de laquelle une ligne électrique de référence prédéterminée, de diamètre plus grand que le diamètre de la ligne électrique 202, n'est plus détectée par les électrodes de mesure 108 ; et

- une distance maximale, notée $D_{max}$, au-delà de laquelle un objet de référence prédéterminé de dimension(s) plus petit(s) que l'objet 124, n'est plus détecté par les électrodes de mesure 108.

Comme expliqué plus haut, en prenant des approximations sans trop de perte de généralité, les distances minimale et maximale sont reliées par la relation suivante :

$$D_{min} = \frac{\varepsilon_r L_c}{L_o} D_{max}$$

avec :

- $\varepsilon_r$ la permittivité relative du moyen d'écartement 204,
- $L_c$ la dimension d'une la ligne électrique de référence prédéterminée dont le diamètre est supérieure ou égale au diamètre de la ligne 202, et
- $L_o$ la dimension d'un objet de référence dont la plus petite dimension est inférieure ou égale à la plus petite dimension de l'objet 124, ou la dimension des électrodes de mesure 108, si celle-ci est plus petite.

Suivant un exemple de réalisation non-limitatif donné à titre d'illustration uniquement :

- l'objet de référence peut être une main, de dimension ou de largeur 90 à 100 mm ;
- la ligne de référence peut avoir un diamètre total de l'ordre 5 mm ;
- chaque électrode de mesure peut présenter une largeur de l'ordre de 50 mm;
- la permittivité relative du moyen d'écartement (par exemple une pièce de plastique rigide creuse) peut être 1,5 ; et
- la distance maximale $D_{max}$, déterminée à partir de la dimension des électrodes de mesure 108 et de la capacité minimum $C_{min}$ détectable, comme décrit précédemment, peut être de l'ordre de 100 mm.

Dans ces conditions, on obtient $D_{min}$=15 mm.
Ainsi, en positionnant une ligne électrique 202 de diamètre inférieur ou égal à celui de la ligne de référence (5 mm) dans un intervalle de distances entre $D_{min}$ = 15 mm et $D_{max}$ = 100 mm des électrodes de mesure 108, cette ligne électrique 202 est à la fois non « vue » par les électrodes de mesure 108 (qu'elle ne perturbe donc pas), et positionnée dans la zone de détection 126 du dispositif, de sorte qu'un objet 124 approchant peut être détecté avant d'entrer en contact avec cette ligne électrique 202. Ainsi, la fonction de sécurité de la détection de collisions est maintenue malgré la présence de la ligne électrique 202, et également vis-à-vis de cette ligne électrique 202.
Bien entendu, il peut être souhaitable de définir un intervalle pour positionner la ligne électrique contenu dans l'intervalle ($D_{min}$ ; $D_{max}$), mais éloigné de ses bornes. On peut par exemple définir un intervalle de positionnement d'amplitude moitié ou quart de l'intervalle ($D_{min}$ ; $D_{max}$), positionné autour du milieu de l'intervalle ($D_{min}$ ; $D_{max}$), ou autour d'une autre position. On peut ainsi optimiser à la fois l'absence de détection du câble 202 et la détection d'objets 124 au-delà de ce câble.
Dans l'exemple de la FIGURE 2, le moyen d'écartement 204 se présente sous la forme d'un support qui s'étend entre la surface de l'appareil 200 comportant les électrodes de mesure 108 et la ligne électrique 202. Le support 204 ne déborde pas au-delà de la ligne électrique 202 de manière significative, vu de l'appareil 200.
Ce support 204 peut être par exemple réalisé dans une matière plastique rigide, avec une structure évidée pour maximiser le volume d'air inclus.
Le support 204 est fixé à la surface de l'appareil 200 comportant les électrodes de mesure 108, éventuellement par-dessus des électrodes de mesure 108, par exemple par un collier de préférence diélectrique, ou par tout autre moyen de fixation connu de type vis, collage, etc.
La ligne électrique 202 est fixée au support 204 par exemple par un collier, ou une bride, ou par tout autre moyen.

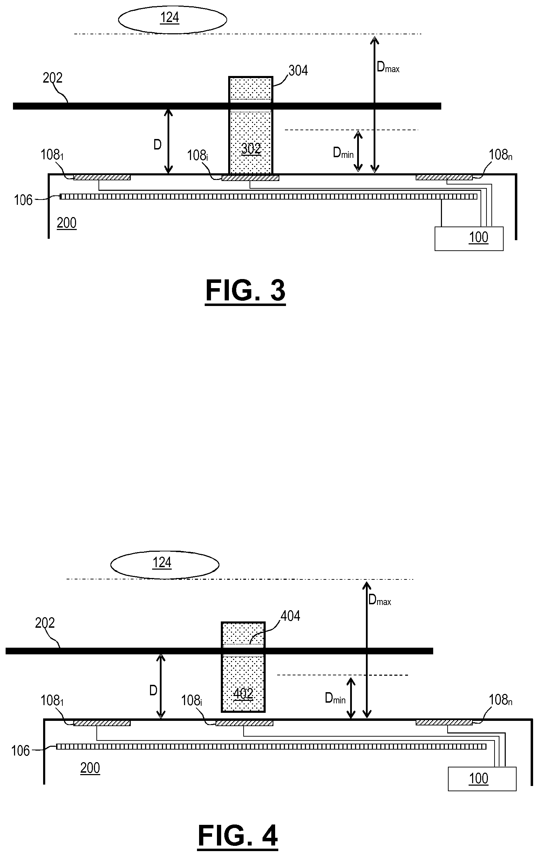

La FIGURE 3 est une représentation schématique d'un autre exemple de réalisation non limitatif d'un moyen d'écartement pouvant être mis en œuvre dans un appareil selon l'invention
L'appareil représenté sur la FIGURE 3 est l'appareil 200 de la FIGURE 2.
A la différence de la FIGURE 2, sur la FIGURE 3, l'appareil 200 comprend un moyen d'écartement réalisé par un support 302 qui s'étend au-delà de la ligne électrique 202. Autrement dit, le support 302 ne s'arrête pas à la ligne électrique 202.
Le support 302 comporte une ouverture de passage 304 dans laquelle est passée le câble 202. L'ouverture de passage 304 peut être fermée. Alternativement, l'ouverture de passage 304 peut être ouverte, par exemple sur le côté du support 302 ou au niveau d'une extrémité libre dudit support 302, pour y positionner la ligne électrique 202.
Le support 302 est fixé à la surface de l'appareil 200 comportant les électrodes de mesure 108, par exemple par un collier de préférence diélectrique, ou par collage.
Le support 302 est de préférence réalisé dans un matériau souple et élastique, par exemple en mousse, destiné à s'écraser si un objet 124 arrive en appui sur sa face terminale opposée aux électrodes de mesure 108. Ainsi, on évite la présence d'un élément potentiellement blessant sur l'appareil 200.
En outre, et en particulier si le support 302 s'étend au-delà de la zone de détection 126, il peut être agencé de sorte que, en cas d'appui ou d'écrasement, le câble 202 se déplace vers les électrodes de mesure 108 à une distance qui permet sa détection par ces électrodes 108, ce qui permet de détecter la présence d'un objet même au-delà de la zone de détection 126.
La FIGURE 4 est une représentation schématique d'un autre exemple de réalisation non limitatif d'un moyen d'écartement pouvant être mis en œuvre dans un appareil selon l'invention

L'appareil représenté sur la FIGURE 4 est l'appareil 200 de la FIGURE 2.

A la différence de la FIGURE 2, sur la FIGURE 4, l'appareil 200 comprend un moyen d'écartement réalisé par une entretoise 402 qui est fixée à la ligne électrique 202, et non plus à la surface de l'appareil 200 comportant les électrodes de mesure 108.

L'entretoise 402 s'étend de part et d'autre de la ligne électrique 202, de manière symétrique ou non symétrique.

L'entretoise 402 comporte une ouverture de passage 404 dans laquelle est passée le câble 202. L'ouverture de passage 404 peut être fermée. Alternativement, l'ouverture de passage 404 peut être ouverte, par exemple sur le côté de l'entretoise 402 ou au niveau d'une extrémité libre de l'entretoise 402, pour y positionner la ligne électrique 202.

L'entretoise 402 peut être fixe, ou mobile, le long de la ligne électrique 202.

L'entretoise 402 peut être réalisée, par exemple :

- sous la forme d'une coque, rigide, flexible ou souple, placée autour du câble 202 et qui emprisonne un volume d'air ou de gaz ;
- sous la forme d'un élément gonflable ;
- en mousse ; ou
- sous la forme d'une brosse cylindrique à poils radiaux.

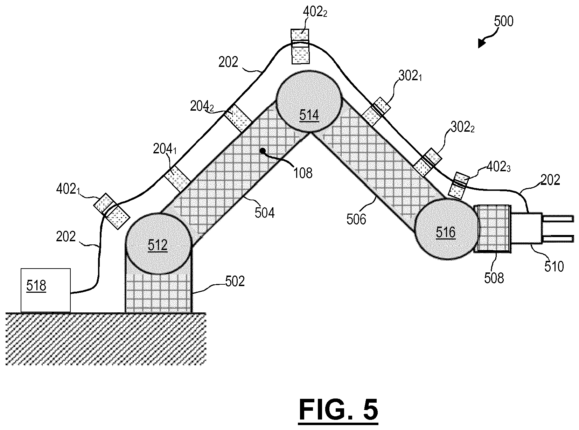

La FIGURE 5 est une représentation schématique d'un autre exemple de réalisation non limitatif d'un appareil selon l'invention.

L'appareil 500, représenté sur la FIGURE 5, est un robot et en particulier un bras robotisé tel qu'un robot collaboratif industriel travaillant sous la surveillance, ou en collaboration avec, un opérateur, ou encore un robot médical en vue d'une intervention sur le corps d'une personne, ou encore un robot d'assistance à la personne.

Le bras robotisé 500 comprend un segment fixe 502, trois segments articulées 504-508 et une tête fonctionnelle 510 fixée au segment articulé 508. La tête fonctionnelle 510 est une pince munie d'un moteur électrique (non représenté).

Le bras robotisé 500 comprend trois articulations 512-514, en particulier motorisées, permettant d'orienter les segments 504-508 selon la configuration souhaitée.

Chaque segment 502-508 est équipé d'électrodes de mesures 108 pour réaliser une détection capacitive d'objets se trouvant dans l'environnement du robot 500, en particulier déposées dans/sur la coque extérieure dudit segment.

Le bras robotisé 500 comprend une ligne électrique, telle que par exemple la ligne électrique 202, pour alimenter la tête fonctionnelle 510 et/ou pour communiquer avec la tête fonctionnelle 510 et, un module 518 d'alimentation et/ou de communication relié à la ligne 202.

Le bras robotisé 500 comprend, au niveau du segment 504, deux supports d'écartement $204_1$ et $204_2$, fixés au segment 504, pour écarter la ligne électrique 202 des électrodes de mesure 108 disposées sur ce segment 504. Chacun des supports d'écartement $204_1$ et $204_2$ peut être le support d'écartement 204 de la FIGURE 2.

Le bras robotisé 500 comprend, au niveau du segment 506, deux supports d'écartement $302_1$ et $302_2$, fixés au segment 506, pour écarter la ligne électrique 202 des électrodes de mesure 108 disposées sur ce segment 506. Chacun des supports d'écartement $302_1$ et $302_2$ peut être le support d'écartement 302 de la FIGURE 3.

Le bras robotisé 500 comprend, au niveau de chaque articulation 512-516 une entretoise d'écartement, respectivement $402_1$, $402_2$ et $402_3$, fixée à la ligne électrique 202, pour écarter la ligne électrique 202 des électrodes de mesure 108 disposées sur le bras robotisé 500. Chacune des entretoises d'écartement $402_1$, $402_2$ et $402_3$ peut être l'entretoise d'écartement 402 de la FIGURE 4.

Bien sûr, l'invention n'est pas limitée aux exemples qui viennent d'être décrits et de nombreux aménagements peuvent être apportés à ces exemples sans sortir du cadre de l'invention défini par les revendications ci-jointes.

## Revendications

1. Appareil (200;500) comprenant :

    - au moins une électrode (108), dite de mesure, polarisée à un potentiel électrique alternatif ($V_G$), dit de détection, différent d'un potentiel de masse (104), à une fréquence, dite de détection, pour détecter au moins un objet (124) dans une zone de détection (126), et
    - au moins une électronique de détection capacitive (100), reliée à ladite ou lesdites électrodes de mesure (108), pour détecter un signal relatif à un couplage capacitif entre ledit objet (124) et ladite électrode de mesure ou au moins une desdites électrodes de mesure (108) ;

    **caractérisé en ce que** ledit appareil (200;500) comprend en outre :

    - une ligne électrique (202) comprenant au moins un fil électrique, dans ladite zone de détection (126) ;
    - au moins un moyen d'écartement (204;302;402) de ladite ligne électrique (202) pour la positionner à une distance de l'au moins une électrode de mesure (108) comprise entre :

- une distance (D$_{min}$), dite minimale, correspondant à la distance au-delà de laquelle une ligne électrique, dite de référence, avec une dimension prédéterminée, génère une capacité de couplage avec l'au moins une électrode de mesure (108), inférieure à une capacité seuil prédéterminée ; et

- une distance (D$_{max}$), dite maximale, correspondant à la distance au-delà de laquelle un objet, dit de référence, avec une dimension prédéterminée, supérieure à la dimension de ladite ligne électrique de référence, génère une capacité de couplage avec l'au moins une électrode de mesure (108) inférieure à ladite capacité seuil.

2. Appareil (200;500) selon la revendication précédente, **caractérisé en ce que** la capacité seuil est déterminée en prenant en compte :

   - une capacité limite de détection, dépendant d'un niveau de bruit de détection de l'électronique de détection capacitive (100) ; et/ou
   - une capacité à l'infini, telle que mesurée par l'électronique de détection (100) capacitive en l'absence d'objet ou de ligne électrique.

3. Appareil (200;500) selon l'une quelconque des revendications précédentes, **caractérisé en ce que** la dimension de la ligne électrique de référence correspond à un diamètre total des conducteurs de ladite ligne de référence.

4. Appareil (200;500) selon l'une quelconque des revendications précédentes, **caractérisé en ce que** la dimension de l'objet de référence correspond à :

   - une largeur ou une longueur de l'objet de référence ; ou
   - une largeur ou une longueur d'un objet de référence de même largeur ou de même longueur que l'au moins une électrode de mesure (108).

5. Appareil (200;500) selon l'une quelconque des revendications précédentes, **caractérisé en ce que** la distance minimale (D$_{min}$) et la distance maximale (D$_{max}$) vérifient la relation suivante :

$$D_{min} = \frac{\varepsilon_r L_c}{L_o} D_{max}$$

avec :

   - $D_{min}$ la distance minimale,
   - $D_{max}$ la distance maximale,
   - $\varepsilon_r$ la permittivité relative globale du moyen d'écartement (204;302;402),

   - L$_c$ la dimension de la ligne électrique de référence, et
   - L$_o$ la dimension de l'objet de référence.

6. Appareil (200;500) selon l'une quelconque des revendications précédentes, **caractérisé en ce qu'**au moins un moyen d'écartement (204;302;402) présente une permittivité diélectrique relative globale inférieure ou égale à 2, en particulier à 1,5.

7. Appareil (200;500) selon l'une quelconque des revendications précédentes, **caractérisé en ce qu'**au moins un moyen d'écartement (204;302) est fixé à une surface dudit appareil (200;500), en particulier à une surface externe dudit appareil (200;500).

8. Appareil (200;500) selon l'une quelconque des revendications précédentes, **caractérisé en ce qu'**au moins un moyen d'écartement (402) est fixé à la ligne électrique (202).

9. Appareil (200;500) selon l'une quelconque des revendications précédentes, **caractérisé en ce qu'**au moins un moyen d'écartement (204;302;402) est souple et s'étend au-delà de la ligne électrique (202), vue depuis l'au moins une électrode de mesure (108).

10. Appareil (200;500) selon l'une quelconque des revendications précédentes, **caractérisé en ce qu'**au moins un moyen d'écartement (204;302;402) est gonflable, et/ou se présente sous la forme d'une brosse cylindrique à poils radiaux, et/ou est au moins en partie, creux, ou spongieux, ou sous forme de mousse.

11. Appareil (200;500) selon l'une quelconque des revendications précédentes, **caractérisé en ce qu'**il comprend au moins une électrode (106), dite de garde, agencée du côté opposé à la zone de détection (126) par rapport aux électrodes de mesure (108), et polarisée à un potentiel, dit de garde (V$_G$), identique au potentiel de détection à la fréquence de détection.

12. Appareil (500) selon l'une quelconque des revendications précédentes, **caractérisé en ce que** la ligne électrique (202) est une ligne d'alimentation, et/ou de commande de, et/ou de communication avec, un organe électrique (510) dudit appareil (500).

13. Appareil (500) selon l'une quelconque des revendications précédentes, **caractérisé en ce qu'**il s'agit d'un robot (500) se présentant sous l'une des formes suivantes : bras robotisé, robot mobile, véhicule sur roues ou chenilles, robot de type humanoïde, ou gynoïde, ou androïde.

**14.** Appareil (500) selon la revendication précédente, **caractérisé en ce qu'**il s'agit d'un robot comprenant au moins deux segments (502-508) reliés entre eux par une articulation (512-516), ledit appareil (500) comprenant au moins un moyen d'écartement (402$_1$-402$_3$) au niveau de ladite articulation (512-516).

**Patentansprüche**

**1.** Vorrichtung (200;500), umfassend:

- mindestens eine Elektrode (108), die als Messelektrode bezeichnet wird, und die vorgespannt ist auf ein Wechselstrompotential (V$_G$), das als Detektionspotential bezeichnet wird, und das von einem Massepotential (104) verschieden ist, bei einer Frequenz, die als Detektionsfrequenz bezeichnet wird, um mindestens ein Objekt (124) in einer Detektionszone (126) zu detektieren, und
- mindestens eine kapazitive Detektionselektronik (100), die mit der genannten oder den genannten Messelektroden (108) verbunden ist, um ein Signal in Bezug auf eine kapazitive Kopplung zwischen dem genannten Objekt (124) und der genannten Messelektrode oder mindestens einer der genannten Messelektroden (108) zu detektieren;

**dadurch gekennzeichnet, dass** die genannte Vorrichtung (200;500) außerdem umfasst:

- eine elektrische Leitung (202), umfassend mindestens einen elektrischen Draht, in der genannten Detektionszone (126);
- mindestens ein Abstandshaltermittel (204;302;402) der genannten elektrischen Leitung (202), um sie in einer Distanz von der mindestens einen Messelektrode (108) zu positionieren zwischen:

■ einer Distanz (D$_{min}$), die als Minimaldistanz bezeichnet wird, und die der Distanz entspricht, jenseits welcher eine elektrische Leitung, die als Referenzleitung bezeichnet wird, mit einer vorherbestimmten Abmessung, eine Kopplungskapazität mit der mindestens einen Messelektrode (108) kleiner als eine vorherbestimmte Schwellenkapazität generiert; und
■ einer Distanz (D$_{max}$), die als Maximaldistanz bezeichnet wird, und die der Distanz entspricht, jenseits welcher ein Objekt, das als Referenzobjekt bezeichnet wird, mit einer vorherbestimmten Abmessung, die größer ist als die Abmessung der genannten elektrischen Referenzleitung, eine Kopplungskapazität mit der mindestens einen Messelektrode (108) kleiner als die vorherbestimmte Schwellenkapazität generiert.

**2.** Vorrichtung (200;500) nach dem vorhergehenden Anspruch, **dadurch gekennzeichnet, dass** die Schwellenkapazität bestimmt wird unter Berücksichtigung:

- einer Kapazitätsdetektionsgrenze, die von einem Detektionsrauschpegel der kapazitiven Detektionselektronik (100) abhängig ist; und/oder
- einer unendlichen Kapazität, wie von der kapazitiven Detektionselektronik (100) in Abwesenheit des Objekts oder der elektrischen Leitung gemessen.

**3.** Vorrichtung (200;500) nach einem der vorhergehenden Ansprüche, **dadurch gekennzeichnet, dass** die Abmessung der elektrischen Referenzleitung einem Gesamtdurchmesser der Leiter der genannten Referenzleitung entspricht.

**4.** Vorrichtung (200; 500) nach einem der vorhergehenden Ansprüche, **dadurch gekennzeichnet, dass** die Abmessung des Referenzobjekts entspricht:

- einer Breite oder einer Länge des Referenzobjekts; oder
- einer Breite oder einer Länge eines Referenzobjekts mit derselben Breite oder mit derselben Länge wie die mindestens eine Messelektrode (108).

**5.** Vorrichtung (200; 500) nach einem der vorhergehenden Ansprüche, **dadurch gekennzeichnet, dass** die Minimaldistanz (D$_{min}$) und die Maximaldistanz (D$_{max}$) die folgende Beziehung erfüllen:

$$D_{min} = \frac{\varepsilon_r L_c}{L_o} D_{max}$$

wobei:

- $D_{min}$ die Minimaldistanz,
- $D_{max}$ die Maximaldistanz,
- $\varepsilon_r$ die gesamte relative Permittivität des Abstandshaltermittels (204; 302; 402),
- L$_c$ die Abmessung der elektrischen Referenzleitung, und
- L$_o$ die Abmessung des Referenzobjekts ist.

**6.** Vorrichtung (200; 500) nach einem der vorhergehenden Ansprüche, **dadurch gekennzeichnet, dass** mindestens ein Abstandshaltermittel (204;302;402) eine gesamte relative dielektrische Permittivität kleiner oder gleich 2, insbesondere 1,5, aufweist.

7. Vorrichtung (200; 500) nach einem der vorhergehenden Ansprüche, **dadurch gekennzeichnet, dass** mindestens ein Abstandshaltermittel (204;302) an einer Fläche der genannten Vorrichtung (200;500) befestigt ist, insbesondere an einer Außenfläche der genannten Vorrichtung (200;500).

8. Vorrichtung (200; 500) nach einem der vorhergehenden Ansprüche, **dadurch gekennzeichnet, dass** mindestens ein Abstandshaltermittel (402) an der elektrischen Leitung (202) befestigt ist.

9. Vorrichtung (200; 500) nach einem der vorhergehenden Ansprüche, **dadurch gekennzeichnet, dass** mindestens ein Abstandshaltermittel (204;302;402) nachgiebig ist und sich über die elektrische Leitung (202) hinaus erstreckt, gesehen von der mindestens einen Messelektrode (108).

10. Vorrichtung (200;500) nach einem der vorhergehenden Ansprüche, **dadurch gekennzeichnet, dass** mindestens ein Abstandshaltermittel (204;302;402) aufblasbar ist und/oder sich in der Form einer Bürstenwalze mit radialen Borsten präsentiert und/oder mindestens teilweise hohl oder schwammartig oder in der Form eines Schaums ist.

11. Vorrichtung (200;500) nach einem der vorhergehenden Ansprüche, **dadurch gekennzeichnet, dass** sie mindestens eine Elektrode (106) umfasst, die als Schutzelektrode bezeichnet wird, die auf der gegenüberliegenden Seite der Detektionszone (126) in Bezug auf die Messelektroden (108) angeordnet ist, und die auf ein Potential vorgespannt ist, das als Schutzpotential ($V_G$) bezeichnet wird, und das mit dem Detektionspotential bei der Detektionsfrequenz identisch ist.

12. Vorrichtung (500) nach einem der vorhergehenden Ansprüche, **dadurch gekennzeichnet, dass** die elektrische Leitung (202) eine Versorgungs- und/oder Steuer- und/oder Kommunikationsleitung mit einem elektrischen Element (510) der genannten Vorrichtung (500) ist.

13. Vorrichtung (500) nach einem der vorhergehenden Ansprüche, **dadurch gekennzeichnet, dass** es sich um einen Roboter (500) handelt, der sich in einer der folgenden Formen präsentiert: Roboterarm, mobiler Roboter, Fahrzeug auf Rädern oder Ketten, Roboter vom humanoiden, gynoiden oder androiden Typ.

14. Vorrichtung (500) nach dem vorhergehenden Anspruch, **dadurch gekennzeichnet, dass** es sich um einen Roboter handelt, umfassend mindestens zwei Segmente (502-508), die miteinander durch ein Gelenk (512-516) verbunden sind, wobei die genannte Vorrichtung (500) mindestens ein Abstandshaltermittel ($402_1$-$402_3$) auf der Höhe des genannten Gelenks (512-516) umfasst.

## Claims

1. Appliance (200;500) comprising:

   - at least one electrode (108), called measurement electrode, polarized at an alternating electrical potential ($V_G$), called detection electrical potential, different from a ground potential (104), at a frequency, called detection frequency, in order to detect at least one object (124) in a detection zone (126), and
   - at least one capacitive detection electronics (100), connected to said measurement electrodes (108), in order to detect a signal with respect to a capacitive coupling between said object (124) and said measurement electrode or at least one of said measurement electrodes (108);

   **characterized in that** said appliance (200;500) also comprises:

   - an electric line (202), comprising at least one electric wire, in said detection zone (126);
   - at least one spacing means (204;302;402) for distancing said electric line (202) in order to position it at a distance from the at least one measurement electrode (108) comprised between:

     - a distance ($D_{min}$), called minimum distance, corresponding to the distance beyond which an electric line, called reference electric line, with a predetermined dimension, generates a coupling capacitance with the at least one measurement electrode (108), less than a predetermined threshold capacitance; and
     - a distance ($D_{max}$), called maximum distance, corresponding to the distance beyond which an object, called reference object, with a predetermined dimension, greater than the dimension of said reference electric line, generates a coupling capacitance with the at least one measurement electrode (108), less than said threshold capacitance.

2. Appliance (200;500) according to the preceding claim, **characterized in that** the threshold capacitance is determined by taking account of:

- a capacitance detection limit, dependent on a detection noise level of the capacitive detection electronics (100); and/or
- an infinite capacitance, as measured by the capacitive detection electronics (100) in the absence of an object or electric line.

**3.** Appliance (200;500) according to any one of the preceding claims, **characterized in that** the dimension of the reference electric line corresponds to a total diameter of the conductors of said reference line.

**4.** Appliance (200;500) according to any one of the preceding claims, **characterized in that** the dimension of the reference object corresponds to:

- a width or a length of the reference object; or
- a width or a length of a reference object of the same width or the same length as the at least one measurement electrode (108).

**5.** Appliance (200;500) according to any one of the preceding claims, **characterized in that** the minimum distance ($D_{min}$) and the maximum distance ($D_{max}$) verify the following relationship:

$$D_{min} = \frac{\varepsilon_r L_c}{L_o} D_{max}$$

with:

- $D_{min}$ the minimum distance,
- $D_{max}$ the maximum distance,
- $\varepsilon_r$ the overall relative permittivity of the spacing means (204;302;402),
- $L_c$ the dimension of the reference electric line, and
- $L_o$ the dimension of the reference object.

**6.** Appliance (200;500) according to any one of the preceding claims, **characterized in that** at least one spacing means (204;302;402) has an overall relative dielectric permittivity less than or equal to 2, in particular 1.5.

**7.** Appliance (200;500) according to any one of the preceding claims, **characterized in that** at least one spacing means (204;302) is fixed to a surface of said appliance (200;500), in particular to an outer surface of said appliance (200;500).

**8.** Appliance (200;500) according to any one of the preceding claims, **characterized in that** at least one spacing means (402) is fixed to the electric line (202).

**9.** Appliance (200; 500) according to any one of the preceding claims, **characterized in that** at least one spacing means (204; 302; 402) is flexible and extends beyond the electric line (202), seen from the at least one measurement electrode (108).

**10.** Appliance (200;500) according to any one of the preceding claims, **characterized in that** at least one spacing means (204; 302; 402) is inflatable, and/or has the form of a cylindrical brush with radial bristles, and/or at least partly hollow, or spongy, or in the form of a foam.

**11.** Appliance (200;500) according to any one of the preceding claims, **characterized in that** it comprises at least one electrode (106), called guard electrode, arranged on the side opposite the detection zone (126) with respect to the measurement electrodes (108), and polarized at a potential, called guard potential ($V_G$), that is identical to the detection potential at the detection frequency.

**12.** Appliance (500) according to any one of the preceding claims, **characterized in that** the electric line (202) is a line for the electric power supply of, and/or for control of, and/or for communication with, an electric component part (510) of said appliance (500).

**13.** Appliance (500) according to any one of the preceding claims, **characterized in that** it is a robot (500) in one of the following forms: robotized arm, mobile robot, vehicle on wheels or tracks, robot of the humanoid, or gynoid, or android type.

**14.** Appliance (500) according to the preceding claim, **characterized in that** it is a robot comprising at least two segments (502-508) connected together by an articulation (512-516), said appliance (500) comprising at least one spacing means ($402_1$-$402_3$) at said articulation (512-516).

13

## FIG. 1

## FIG. 2

**FIG. 3**

**FIG. 4**

**FIG. 5**

**EP 3 823 798 B1**

## RÉFÉRENCES CITÉES DANS LA DESCRIPTION

**Documents brevets cités dans la description**

- US 5166679 A